Europäisches Patentamt

European Patent Office

Office européen des brevets

(19)

(11) Publication number : **0 484 072 A2**

## (12) EUROPEAN PATENT APPLICATION

(21) Application number : **91309920.6**

(22) Date of filing : **28.10.91**

(51) Int. Cl.⁵ : **H03M 5/14**

(30) Priority : **29.10.90 US 605288**

(43) Date of publication of application :
**06.05.92 Bulletin 92/19**

(84) Designated Contracting States :
**DE FR GB**

(71) Applicant : **International Business Machines Corporation**
**Old Orchard Road**
**Armonk, N.Y. 10504 (US)**

(72) Inventor : **Lynch, Robert T.**
**6726 Mt. Pakron Drive**
**San Jose, CA 95120 (US)**
Inventor : **Rugar, Daniel**
**228 Webster Street**
**Palo Alto, CA 94301 (US)**
Inventor : **Weigandt, Todd Charles**
**351 Manila Drive**
**San Jose, CA 95119 (US)**

(74) Representative : **Mitchell, Allan Edmund**
**IBM United Kingdom Limited Intellectual**
**Property Department Hursley Park**
**Winchester Hampshire SO21 2JN (GB)**

(54) **Apparatus and method for binary data encoding and decoding.**

(57)    Serial binary input data is converted to serial binary code data that satisfies a (2,18,2) constraint and is reconverted to the serial binary input data. An encoder 11 receives two sequential input bits and a five-bit state vector derived from an immediately preceding encoding operation, and generates a five-bit codeword and a new five-bit state vector based on said two input bits and five-bit state vector. A decoder 16 converts each five-bit codeword sequentially into a reassigned three-bit codeword representation, then collects sets of four adjacent three-bit codeword representations. Each reassigned codeword representation is converted to a two-bit output corresponding to a then current set of said four three-bit codeword representations, and successive two-bit outputs are reconverted into the serial binary data.

FIG. 2

Field of the Invention

This invention relates to run length limited codes that allow high density recording for optical and/or magnetic storage media, and more particularly to encoding and decoding with a rate 2/5 even-consecutive-zero constraint (2,18,2) code that is especially suitable for use with a resonant coil direct overwrite technique for magneto-optical recording.

Background of the Invention

Run length limited (RLL) codes with an even-consecutive-zero constraint (i.e, an even number of "0" code bits between each "1" code bit) in addition to the usual d,k constraints, have heretofore been proposed and are designated (d,k,2).

For example, U.S. Patent 4,928,187 describes a (2,8,2) code which means that it has run lengths of either 2, 4, 6 or 8 "0" code bits between each "1" code bit. This code is described as useful for a magnetic or optical medium data storage system. It has a rate 1/3, which means that for every data bit three code bits are required.

In the IEEE Transactions Magnetics, MAG-18, pp. 772-775 published in 1982, Funk described a similar rate 1/3 code satisfying the (2,8,2) constraint for magnetic recording.

In the Proceedings of the Optical Data Storage Topical Meeting (1989) reported in SPIE Vol. 1078 at pp. 265-270, it was reported that a rate 2/5 (2,18,2) code can be constructed using sliding block code techniques. However, no information was provided on how the code can be constructed or implemented. This (2,18,2) code requires five code bits for every two data bits and hence has a higher rate than the rate 1/3 codes. It is especially suitable for use with a resonant coil magneto-optic direct overwrite technique such as that described in U.S. Patent 4,872,078, which discloses the only presently known field modulation overwrite technique compatible with parallel recording.

Disclosure of the Invention

Accordingly, the invention provides an encoder for converting binary input data to binary code data that satisfies a (2,18,2) constraint, said encoder comprising: means to receive two sequential input bits and a five-bit state vector derived from an immediately preceding encoding operation; and means for generating a five-bit codeword and a new five-bit state vector based on said two input bits and five-bit state vector; said five-bit codeword being chosen from one of the following eight possible codewords: 00000, 00001, 00010, 00100, 01000, 10000, 10010, 01001.

The invention also provides a decoder for converting a string of serial rate 2/5 code data to serial binary data comprising: means for converting the serial string to 4 5-bit codewords; means for converting each 5-bit codeword into a reassigned 3-bit codeword representation; means for collecting sets of 4 adjacent 3-bit codeword representations; means for converting each reassigned codeword representation to an 2-bit output corresponding to a then current set of 4 3-bit codeword representations; and means for converting successive 2-bit output into the serial binary data.

The invention further provides a method of encoding for converting binary input data to binary code data that satisfies a (2,18,2) constraint, comprising the steps of: converting binary input data into sequential sets of two input bits; deriving from an immediately preceding encoding operation a five-bit state vector; providing eight possible codewords: 00000, 00001, 00010, 00100, 01000, 10000, 01001; and from said two input bits and five-bit state vector, generating an appropriate one of said possible five-bit codewords.

The invention further provides a method of decoding a string of serial binary code data to serial binary data, comprising the steps of: converting the serial string into j n-bit codewords; converting each n-bit codeword into a reassigned k-bit codeword representation, where k<n; collecting sets of j adjacent k-bit codeword representations; converting each reassigned codeword representation to an m-bit output corresponding to a then current set of j k-bit codeword representations; and converting successive m-bit outputs into the serial binary data.

In one preferred embodiment serial binary input data is converted to serial binary code data that satisfies a (2,18,2) constraint and is reconverted to the serial binary input data. An encoder receives two sequential input bits and a five-bit state vector derived from an immediately preceding encoding operation, and generates a five-bit codeword and a new five-bit state vector based on said two input bits and five-bit state vector. A decoder converts the binary code data into five-bit codewords, converts each five-bit codeword sequentially into a reassigned three-bit codeword representation, then collects sets of four adjacent three-bit codeword representations. Each reassigned codeword representation is converted to a two-bit output corresponding to a then current set of said four three-bit codeword representations, and successive two-bit outputs are reconverted into the serial binary data.

The (2,18,2) code has been found to be (a) superior to the (1,7), (2,7) and (2,8,2) codes when used for pulse width modulation (PWM) recording with either maximum slope or threshold detection channels; (b) superior to all other codes thus far modelled for optical partial response maximum likelihood (PRML) type channels, including (1,7) at linear densities above 45 kbpi; and (c) less susceptible to the effects of domain size variation. The main advantage of the (2,18,2) code in bit-by-bit detection is due to the wider detection window for a given user data density. The wide window is a consequence of the even-zero constraint which disallows every other clock period as a potential edge location.

Thus a preselected number of bits of binary input data can be coded into a string of binary code data by apparatus comprising: a finite state machine for encoding, from the input data, sequences of binary code bits such that there are between one and nine pairs of consecutive $\emptyset$'s between binary 1's and the ratio of the number of bits in the input data to the number of bits in the code string is 2/5, said finite state machine being operative (a) to output a five-bit codeword that is determined by a then current state of said machine and values of two bits chosen sequentially from said input data and (b) to select the next state of said machine from said current state and values of said two sequentially chosen bits. The five-bit codeword is selected from one of the following eight possible codewords: 00000, 00001, 00010, 00100, 01000, 10000, 10010 and 01001, and the finite state machine has 25 states.

## Brief Description of the Drawings

Fig. 1 is a finite state transition diagram depicting the (2,18,2) code;
Fig. 2 is a block diagram of a data storage system;
Fig. 3 is a block diagram of the encoder of Figure 2;
Fig 4 is a block diagram of the decoder of Figure 2; and
Fig. 5 is a timing diagram of the control signals for the decoder.

## Detailed Description

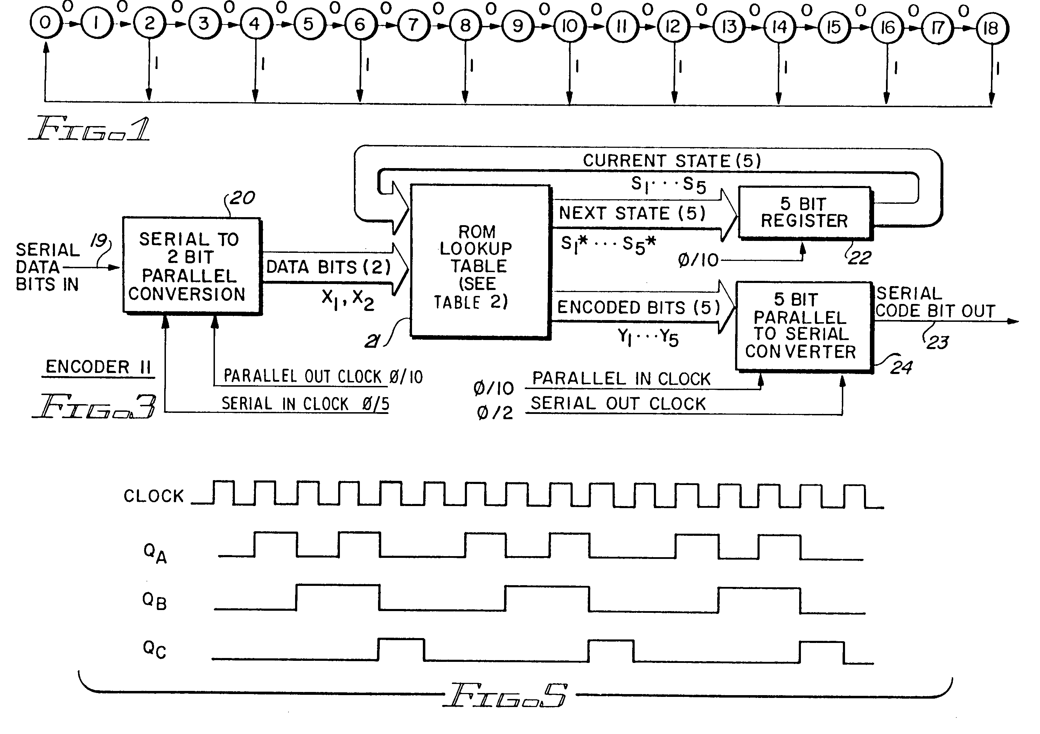

The (2,18,2) code is a run length limited code with traditional (d,k) constraints and the additional constraint that all run lengths of consecutive zeros are even. The d=2 constraint serves to limit intersymbol interference and k=18 guarantees transitions close enough for timing recovery. The (2,18,2) code can be described by the finite state transition diagram shown in Fig. 1. The capacity of the (2,18,2) constraint is sufficient to allow a rational code rate of 2/5.

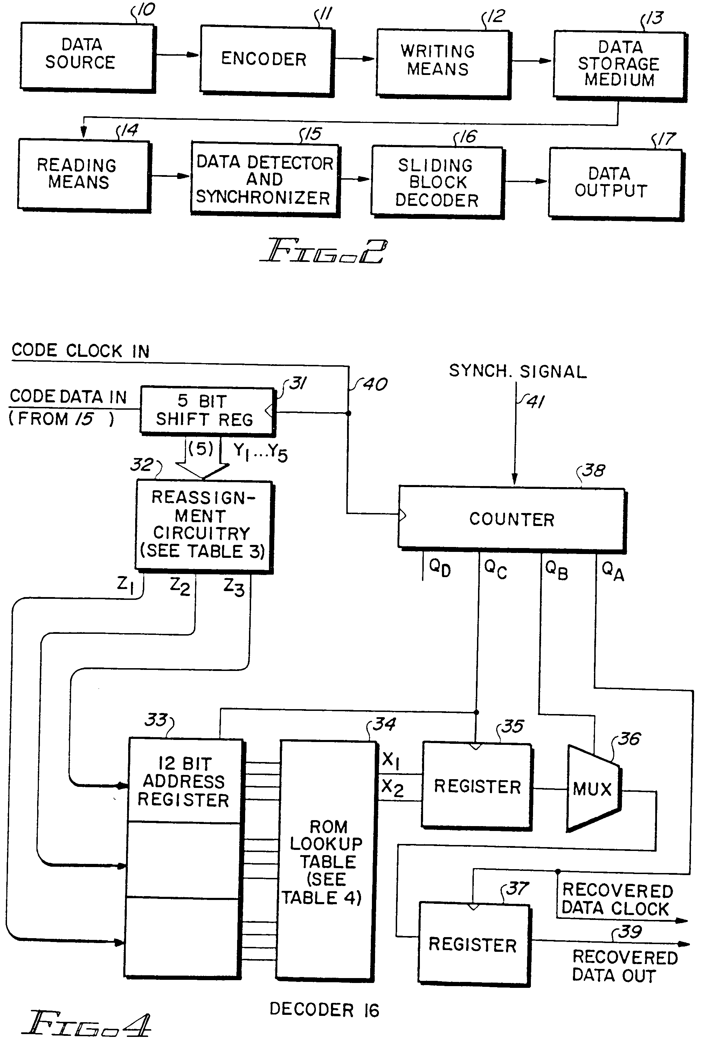

Fig. 2 illustrates a data storage system employing a (2,18,2) code and embodying the invention. A binary data stream from a source 10 is converted into a (2,18,2) code bit stream by an encoder 11. The code bit stream controls a writing means 12, such as a diode laser and associated electronics in an optical disk system or a magnetic recording head and associated electronics in a magnetic disk or tape system. The information, as encoded into (2,18,2) code by encoder 11, is written onto a medium 13, such as an optical or magnetic disk in the form of marks in the case of optical media or magnetic transitions in the case of magnetic media. The written marks or transitions are read back as an analog signal by a reading means 14, which may include a laser beam or magnetic reading head. This analog signal is converted back into a digital data stream representing the code data by a data detector and synchronizer 15 that is suitable for codes with even consecutive zeros and may be of the type described in the proceedings of the IEEE International Conference on Communications, April 16-19, 1990, at pages 1729-1733. The data output of data detector and synchronizer 15 is decoded by a decoder 16 which converts the. (2,18,2) code data back to the original binary representation.

An algorithm for sliding block codes is described in IEEE Transactions on Information Theory, published January 1983 at pp. 5-22. This algorithm is described in more condensed form in IEEE Transactions on Magnetics, published September 1985, at pp. 1348-1349. These articles describe state-splitting and state-merging.

The applicants found that, by manipulation of the finite state transition diagram of Fig. 1 for the (2,18,2) code and making selective use of state-splitting methods, a finite state machine (FSM) with only 25 states and four outgoing edges per state could be used to define the (2,18,2) encoding algorithm. This FSM is depicted in Table 1 (see Appendix). It describes the encoding rules used by encoder 11 and, because of its simplicity, allows practical implementation of a (2,18,2) code.

Each edge of the FSM is represented by an entry in Table 1. Edges are selected during the encoding process according to the current state of the FSM and a two-bit input label. Each edge specifies a five-bit codeword and next state of the FSM. Encoded data is produced by tracing a path through the FSM. With each new set of two input bits, the correct edge is chosen from the current state and the codeword associated with the edge is output by encoder 11.

Thus, two bits of input data and the current state of the FSM serve to specify the five-bit codeword plus the next state of the FSM. Note that there are only 8 possible choices of codewords: 00000, 00001, 00010, 00100, 01000, 10000, 01001 and 10010.

The FSM in Table 1 was generated with only four rounds of state-splitting, which together with selective input edge assignment, enabled the design of a decoder having a window of only four codewords, an important feature of the invention. This limits error propagation upon decoding to eight bits. The two-hit input labels for each edge in Table 1 are chosen so as to allow unique decoding by a sliding block decoder.

Fig. 3 illustrates the manner in which the FSM described in Table 1 can be implemented in hardware. Since the FSM has 25 states, at least five bits are required to represent a particular one of the states. The five state bits are identified as s1, ..., s5 and the two input data bits as x1 and x2. These seven bits generate the codeword y1, ..., y5 and the next state s1*, ..., s5*. The clock $\Phi$ has a frequency that is five times higher than the bit rate of the input data stream and twice the bit rate of the code data. The other clocks, $\Phi/2$, $\Phi/5$ and $\Phi/10$, are derived from $\Phi$ by frequency division by suitable means (not shown).

In encoder 11, serial input data 19 is converted to two parallel bits x1,x2 by a serial-to-parallel converter 20 which may be a serial-in, parallel-out shift register. The two parallel data bits x1 and x2 plus five state bits s1, ..., s5 that identify the present state of encoder 11 are supplied to, and specify the address of a memory location in, a read only memory (ROM) 21.. ROM 21 serves as a look-up table to generate the codeword bits y1, ..., y5 and the bits s1*, ..., s5* describing the next state of encoder 11. Register 22 holds the value of the current state of the FSM while the next state and codeword are generated. The codeword bits y1, ..., y5 are converted into a serial data stream 23 by parallel-to-serial converter 24 which may be a parallel-in, serial-out shift register. The encoding rules for the (2,18,2) encoder 11 can be converted into a truth table such as specified in Table 2 (see Appendix) by assigning a unique binary label to each state.

As illustrated, Table 2 specifies the contents of ROM 21 for the case where states 1, ..., 25 of the FSM have been assigned the binary values 00001, ..., 11001; however, any other consistent assignment of binary values to FSM state labels may be used, if preferred. (In Table 2 the first column represents the two input bits, the second column represents the input state of the finite state machine, the third column represents the output state of the finite state machine, and the final column represents the five-bit output codeword).

If desired, the truth table in Table 2 can also be converted into logic equations using standard logic minimization techniques. ROM 21 can then be replaced by suitable combinational logic circuitry. For example, the logic expression for $y_1$ would be

$$y_1 = x_1 x_2 \overline{s_1} s_4 \overline{s_5} + \overline{s_1} s_2 s_4 \overline{s_5} + \overline{s_1} s_3 s_4 + \overline{s_1} s_3 \overline{s_4}.$$

Referring now to Fig. 4, decoder 16 for the (2,18,2) code uses a sliding window to convert five-bit codewords y1, ..., y5 back to the correct two-bit sequences x1,x2, representing the recovered data. The input data stream for decoder 16 consists of concatenated five-bit codewords. In order to determine x1,x2, the current codeword and the three following codewords must be examined. Decoder 16 looks at a window of four five-bit codewords (a total of 20 bits) and produces the correct translation of the first one. When five new code bits are received, the window shifts forward one codeword and the process repeats. Although the decoder window is 20-bits wide, the same information can be conveyed in a 12-bit form by adopting the codeword reassignment shown in Table 3 (see Appendix). This is possible since there are only eight different five-hit codewords output by encoder 11. These five-bit codewords y1, ..., y5 are reassigned the smaller three-bit label z1,z2,z3 when receive.d. These three-bit codewords are then used to form the needed window of four words, resulting in only 12 bits total. This reduction from 20 bits to 12 bits greatly reduces the size the circuitry used to determine recovered data bits.

More specifically, and as illustrated in Fig. 4, shift register 31 receives encoded data serially from data detector and synchronizer 15 and presents it in parallel to combinational codeword reassignment logic circuitry 32. Circuitry 32 receives five-bit codeword y1, ..., y5 in parallel and converts it to a new three-bit representation z1,...,z3, as specified in Table 3. These three-bit codewords are made available in parallel to a twelve-bit address register 33. Address register 33 comprises three four-bit shift registers. Every fifth clock cycle a new codeword z1,z2,z3 is shifted into address register 33; with z1 going to the first shift register, z2 to the second, and z3 to the third. These shift registers are four bits wide, so together they hold twelve bits of window information. This twelve-bit window addresses a look-up table in a ROM 34. The output of ROM 34 is the two bits x1,x2 decoded from the current codeword. These bits x1,x2 are then serialized through a register 35, multiplexor 36 and register 37 to provide recovered serial binary data in line 39.

The control signals for decoder 1.6 are all generated from outputs QA,QB,QC from a counter 38 in response to clock pulses in line 40. Output QC is used to load new three-bit reassigned codewords into address register 33. Output QC also clocks x1,x2 pairs into register 35 where they can be held while serialized out through the combination of multiplexor 36 and register 37. Output QB is an input to the multiplexor which selects between x1 and x2, thus determining which data is being fed to register 37. Output QA serves as the output data clock and controls the clocking of data from the multiplexor into register 37.

The relationship between these control signals is shown in Fig. 5. The serial output issues with an asymmetrical clock having two output pulses for every five code clock pulses (as required for a rate 2/5 code). Counter 38 relies on the synchronization signal in line 41 to correctly align the decoder window. This synchronization signal is generated from a preamble that initiates the data stream.

The contents of ROM 34 (shown in Table 4 of Appendix) are key to the operation of decoder 16. The look-up table was derived by considering all possible four codeword sequences generated by the encoder FSM, and choosing the correct x1,x2 for recovery in each case. There are a total of 100 edges (25 states x 4 edges per state) in encoder 11. In some cases, there are identical codeword sequences (also called edge sequences) that begin in different states. Each sequence begins with a different edge, hut must decode to the same input if decoding is to be unique.

The encoder FSM in Table 1 was designed with input assignments that allow these equivalent edge sequences to decode to the same x1,x2. The look-up truth table in Table 4 is written in terms of the three-bit codeword names or representations as reassigned in Table 3. The entries are written left to right with the oldest codeword (the one to be translated) at the left and the three following codewords (needed for the decoding window) to the right. When a new codeword is received, it shifts into the window from the right, as the oldest word (now decoded) shifts out to the left.

While the truth tables of Tables 2 and 4 were illustrated as implemented using ROMs 21 and 34, respectively, it will be understood that, if preferred, they may be implemented either in discrete logic circuitry or programmable logic arrays.

APPENDIX

Table 1.  Finite State Machine for (2,18,2) Encoder

| Current State | INPUT DATA | | | |
|---|---|---|---|---|
| | 00 | 01 | 10 | 11 |
| | *      ** | *      ** | *      ** | *      ** |
| 01 | 04-00100 | 17-00100 | 18-00100 | 19-00100 |
| 02 | 06-00100 | 20-00100 | 21-00100 | 22-00100 |
| 03 | 01-00100 | 02-00100 | 03-00100 | 05-00100 |
| 04 | 13-00000 | 14-00000 | 15-00000 | 16-00000 |
| 05 | 08-00000 | 11-00000 | 23-00000 | 10-00000 |
| 06 | 04-00001 | 05-00001 | 06-00001 | 07-00001 |
| 07 | 01-00001 | 02-00001 | 03-00001 | 09-00000 |
| 08 | 13-01000 | 14-01000 | 15-01000 | 16-01000 |
| 09 | 04-00000 | 17-00000 | 18-00000 | 19-00000 |
| 10 | 20-00000 | 21-00000 | 06-00000 | 22-00000 |
| 11 | 08-01000 | 10-01000 | 11-01000 | 23-01000 |
| 12 | 01-00000 | 02-00000 | 03-00000 | 24-00000 |
| 13 | 13-00010 | 14-00010 | 15-00010 | 16-00010 |
| 14 | 09-00010 | 10-00010 | 11-00010 | 12-00010 |
| 15 | 01-01001 | 02-01001 | 03-01001 | 08-00010 |
| 16 | 04-01001 | 05-01001 | 06-01001 | 07-01001 |
| 17 | 04-10000 | 17-10000 | 18-10000 | 19-10000 |
| 18 | 06-10000 | 20-10000 | 21-10000 | 22-10000 |
| 19 | 01-10000 | 02-10000 | 03-10000 | 05-10000 |
| 20 | 09-10010 | 10-10010 | 11-10010 | 12-10010 |
| 21 | 13-10010 | 14-10010 | 15-10010 | 16-10010 |
| 22 | 01-00001 | 02-00001 | 03-00001 | 08-10010 |
| 23 | 01-00000 | 02-00000 | 03-00000 | 09-01000 |
| 24 | 08-00000 | 11-00000 | 23-00000 | 25-00000 |
| 25 | 20-00000 | 21-00000 | 18-00000 | 19-00000 |

```
        *           **
      next        code
      state       word
```

5

Table 2.   Truth Table for Finite State Machine for
            (2,18,2) Decoder

| | | | |
|---|---|---|---|
| 00 | 00001 | 00100 | 00100 |
| 01 | 00001 | 10001 | 00100 |
| 10 | 00001 | 10010 | 00100 |
| 11 | 00001 | 10011 | 00100 |
| 00 | 00010 | 00110 | 00100 |
| 01 | 00010 | 10100 | 00100 |
| 10 | 00010 | 10101 | 00100 |
| 11 | 00010 | 10110 | 00100 |
| 00 | 00011 | 00001 | 00100 |
| 01 | 00011 | 00010 | 00100 |
| 10 | 00011 | 00011 | 00100 |
| 11 | 00011 | 00101 | 00100 |
| 00 | 00100 | 01101 | 00000 |
| 01 | 00100 | 01110 | 00000 |
| 10 | 00100 | 01111 | 00000 |
| 11 | 00100 | 10000 | 00000 |
| 00 | 00101 | 01000 | 00000 |
| 01 | 00101 | 01011 | 00000 |
| 10 | 00101 | 10111 | 00000 |
| 11 | 00101 | 01010 | 00000 |
| 00 | 00110 | 00100 | 00001 |
| 01 | 00110 | 00101 | 00001 |
| 10 | 00110 | 00110 | 00001 |
| 11 | 00110 | 00111 | 00001 |
| 00 | 00111 | 00001 | 00001 |
| 01 | 00111 | 00010 | 00001 |
| 10 | 00111 | 00011 | 00001 |
| 11 | 00111 | 01001 | 00000 |
| 00 | 01000 | 01101 | 01000 |
| 01 | 01000 | 01110 | 01000 |
| 10 | 01000 | 01111 | 01000 |
| 11 | 01000 | 10000 | 01000 |
| 00 | 01001 | 00100 | 00000 |
| 01 | 01001 | 10001 | 00000 |
| 10 | 01001 | 10010 | 00000 |
| 11 | 01001 | 10011 | 00000 |
| 00 | 01010 | 10100 | 00000 |
| 01 | 01010 | 10101 | 00000 |
| 10 | 01010 | 00110 | 00000 |
| 11 | 01010 | 10110 | 00000 |
| 00 | 01011 | 01000 | 01000 |
| 01 | 01011 | 01010 | 01000 |
| 10 | 01011 | 01011 | 01000 |
| 11 | 01011 | 10111 | 01000 |
| 00 | 01100 | 00001 | 00000 |
| 01 | 01100 | 00010 | 00000 |
| 10 | 01100 | 00011 | 00000 |
| 11 | 01100 | 11000 | 00000 |

Table 2. (continued)

```
00    11001    10100    00000
01    11001    10101    00000
10    11001    10010    00000
11    11001    10011    00000
```

Table 3.  Codeword Reassignment

|  Codeword | Reassigned Word |
| --- | --- |
| $y_1y_2y_3y_4y_5$ | $z_1z_2z_3$ |
| 0 0 0 0 0 | 0 0 0 |
| 0 0 0 0 1 | 0 0 1 |
| 0 0 0 1 0 | 0 1 0 |
| 0 0 1 0 0 | 0 1 1 |
| 0 1 0 0 0 | 1 0 0 |
| 0 1 0 0 1 | 1 0 1 |
| 1 0 0 0 0 | 1 1 0 |
| 1 0 0 1 0 | 1 1 1 |

Logic Equation

$$z_1 = y_1 + y_2$$

$$z_2 = y_1 + y_4 + y_3$$

$$z_3 = y_5 + y_3 + (y_1 y_4)$$

Table 4.  (2,18,2) Look-up Truth Table for (2,13,2) Decoder

| Input | | | | Output |
|---|---|---|---|---|
| $z_1 z_2 z_3$ | $z_1 z_2 z_3$ | $z_1 z_2 z_3$ | $z_1 z_2 z_3$ | $x_1 x_2$ |
| [1] | [2] | [3] | [4] | |
| 0 0 0 | 1 1 1 | 1 0 1 | 0 0 1 | 0 1 |
| 0 0 0 | 1 1 1 | 1 0 1 | 0 0 0 | 0 1 |
| 0 0 0 | 1 1 1 | 0 1 0 | 1 0 0 | 0 1 |
| 0 0 0 | 1 1 1 | 1 0 1 | 0 1 1 | 0 1 |
| 0 0 0 | 1 1 1 | 0 1 0 | 0 0 0 | 0 1 |
| 0 0 0 | 1 1 1 | 0 1 0 | 1 0 1 | 0 1 |
| 0 0 0 | 1 1 1 | 0 0 0 | 0 1 0 | 0 1 |
| 0 0 0 | 1 1 1 | 0 0 0 | 0 0 0 | 0 0 |
| 0 0 0 | 1 1 1 | 0 0 0 | 0 1 1 | 0 0 |
| 0 0 0 | 1 1 1 | 1 0 0 | 0 0 0 | 0 0 |
| 0 0 0 | 1 1 1 | 1 0 0 | 1 0 0 | 0 0 |
| 0 0 0 | 1 1 1 | 0 0 0 | 0 0 1 | 0 0 |
| 0 0 0 | 1 1 1 | 0 0 0 | 1 1 1 | 0 0 |
| 0 0 0 | 1 1 1 | 0 0 0 | 1 1 0 | 0 0 |
| 0 0 0 | 1 1 0 | 0 0 0 | 0 0 0 | 1 1 |
| 0 0 0 | 1 1 0 | 0 0 0 | 1 0 0 | 1 1 |
| 0 0 0 | 1 1 0 | 0 1 1 | 0 0 0 | 1 1 |
| 0 0 0 | 1 1 0 | 0 1 1 | 0 1 1 | 1 1 |
| 0 0 0 | 1 1 0 | 0 1 1 | 0 0 1 | 1 1 |
| 0 0 0 | 1 1 0 | 0 1 1 | 1 1 1 | 1 1 |
| 0 0 0 | 1 1 0 | 0 1 1 | 1 1 0 | 1 1 |
| 0 0 0 | 1 1 0 | 1 1 1 | 1 0 0 | 1 0 |
| 0 0 0 | 1 1 0 | 0 0 1 | 0 1 1 | 1 0 |
| 0 0 0 | 1 1 0 | 1 1 1 | 1 0 1 | 1 0 |
| 0 0 0 | 1 1 0 | 1 1 1 | 0 1 0 | 1 0 |
| 0 0 0 | 1 1 0 | 1 1 1 | 0 0 0 | 1 0 |
| 0 0 0 | 1 1 0 | 0 0 1 | 0 0 1 | 1 0 |
| 0 0 0 | 1 1 0 | 0 0 1 | 0 0 0 | 1 0 |
| 0 0 0 | 0 0 0 | 1 1 1 | 1 0 1 | 1 1 |
| 0 0 0 | 0 0 0 | 1 1 1 | 0 1 0 | 1 1 |
| 0 0 0 | 0 0 0 | 1 1 1 | 0 0 0 | 1 1 |
| 0 0 0 | 0 0 0 | 1 1 1 | 1 0 0 | 1 1 |
| 0 0 0 | 0 0 0 | 1 1 0 | 0 0 0 | 1 1 |
| 0 0 0 | 0 0 0 | 1 1 0 | 0 1 1 | 1 1 |
| 0 0 0 | 0 0 0 | 1 1 0 | 0 0 1 | 1 1 |
| 0 0 0 | 0 0 0 | 1 1 0 | 1 1 1 | 1 1 |
| 0 0 0 | 1 0 0 | 0 0 0 | 1 1 0 | 1 0 |
| 0 0 0 | 1 0 0 | 0 0 0 | 0 0 0 | 1 0 |
| 0 0 0 | 0 0 0 | 0 1 1 | 0 0 0 | 1 0 |
| 0 0 0 | 0 0 0 | 0 1 1 | 0 1 1 | 1 0 |
| 0 0 0 | 0 0 0 | 0 1 1 | 0 0 1 | 1 0 |
| 0 0 0 | 0 0 0 | 0 1 1 | 1 1 1 | 1 0 |
| 0 0 0 | 0 0 0 | 0 1 1 | 1 1 0 | 1 0 |
| 0 0 0 | 1 0 0 | 1 0 0 | 0 0 0 | 0 1 |
| 0 0 0 | 1 0 0 | 0 0 0 | 0 1 1 | 0 1 |
| 0 0 0 | 1 0 0 | 1 0 0 | 1 0 0 | 0 1 |
| 0 0 0 | 1 0 0 | 0 0 0 | 0 0 1 | 0 1 |
| 0 0 0 | 1 0 0 | 0 0 0 | 1 1 1 | 0 1 |
| 0 0 0 | 1 0 0 | 1 0 0 | 1 0 1 | 0 1 |
| 0 0 0 | 1 0 0 | 1 0 0 | 0 1 0 | 0 1 |
| 0 0 0 | 1 0 0 | 1 0 1 | 0 0 1 | 0 0 |
| 0 0 0 | 1 0 0 | 1 0 1 | 0 0 0 | 0 0 |
| 0 0 0 | 1 0 0 | 0 1 0 | 1 0 0 | 0 0 |
| 0 0 0 | 1 0 0 | 1 0 1 | 0 1 1 | 0 0 |

Table 4 (continued)

```
0 0 0    1 0 0    0 1 0    0 0 0    0 0
0 0 0    1 0 0    0 1 0    1 0 1    0 0
0 0 0    1 0 0    0 1 0    0 1 0    0 0
1 0 0    0 0 0    1 1 0    0 0 0    1 1
1 0 0    0 0 0    1 1 0    0 1 1    1 1
1 0 0    0 0 0    1 1 0    0 0 1    1 1
1 0 0    0 0 0    1 1 0    1 1 1    1 1
1 0 0    0 0 0    1 1 0    1 1 0    1 1
1 0 0    0 0 0    0 0 0    1 0 1    1 1
1 0 0    0 0 0    0 0 0    0 1 0    1 1
0 0 0    0 1 1    0 0 0    0 0 0    1 0
0 0 0    0 1 1    0 0 0    1 0 0    1 0
0 0 0    0 1 1    0 1 1    0 0 0    1 0
0 0 0    0 1 1    0 1 1    0 1 1    1 0
0 0 0    0 1 1    0 1 1    0 0 1    1 0
0 0 0    0 1 1    0 1 1    1 1 1    1 0
0 0 0    0 1 1    0 1 1    1 1 0    1 0
0 0 0    0 1 1    1 1 1    1 0 0    0 1
0 0 0    0 1 1    0 0 1    0 1 1    0 1
0 0 0    0 1 1    1 1 1    1 0 1    0 1
0 0 0    0 1 1    1 1 1    0 1 0    0 1
0 0 0    0 1 1    1 1 1    0 0 0    0 1
0 0 0    0 1 1    0 0 1    0 0 1    0 1
0 0 0    0 1 1    0 0 1    0 0 0    0 1
0 0 0    0 1 1    1 1 0    0 0 0    0 0
0 0 0    0 1 1    1 1 0    0 1 1    0 0
0 0 0    0 1 1    1 1 0    0 0 1    0 0
0 0 0    0 1 1    1 1 0    1 1 1    0 0
0 0 0    0 1 1    1 1 0    1 1 0    0 0
0 0 0    0 1 1    0 0 0    1 0 1    0 0
0 0 0    0 1 1    0 0 0    0 1 0    0 0
1 1 1    1 0 0    1 0 1    0 0 1    1 1
1 1 1    1 0 0    1 0 1    0 0 0    1 1
1 1 1    1 0 0    0 1 0    1 0 0    1 1
1 1 1    1 0 0    1 0 1    0 1 1    1 1
1 1 1    1 0 0    0 1 0    0 0 0    1 1
1 1 1    1 0 0    0 1 0    1 0 1    1 1
1 1 1    1 0 0    0 1 0    0 1 0    1 1
0 0 1    0 1 1    0 0 0    0 0 0    1 0
0 0 1    0 1 1    0 0 0    1 0 0    1 0
0 0 1    0 1 1    0 1 1    0 0 0    1 0
0 0 1    0 1 1    0 1 1    0 1 1    1 0
0 0 1    0 1 1    0 1 1    0 0 1    1 0
0 0 1    0 1 1    0 1 1    1 1 1    1 0
0 0 1    0 1 1    0 1 1    1 1 0    1 0
0 0 1    0 1 1    1 1 1    1 0 0    0 1
0 0 1    0 1 1    0 0 1    0 1 1    0 1
0 0 1    0 1 1    1 1 1    1 0 1    0 1
0 0 1    0 1 1    1 1 1    0 1 0    0 1
0 0 1    0 1 1    1 1 1    0 0 0    0 1
0 0 1    0 1 1    0 0 1    0 0 1    0 1
0 0 1    0 1 1    0 0 1    0 0 0    0 1
0 0 1    0 1 1    1 1 0    0 0 0    0 0
0 0 1    0 1 1    1 1 0    0 1 1    0 0
0 0 1    0 1 1    1 1 0    0 0 1    0 0
0 0 1    0 1 1    1 1 0    1 1 1    0 0
0 0 1    0 1 1    0 0 0    1 1 0    0 0
0 0 1    0 1 1    0 0 0    1 0 1    0 0
0 0 1    0 1 1    0 0 0    0 1 0    0 0
1 1 1    1 0 1    0 0 0    0 0 0    1 1
```

Table 4 (continued)

| | | | | | | | | | | | | | |
|---|---|---|---|---|---|---|---|---|---|---|---|---|---|
| 1 | 1 | 1 | 1 | 0 | 1 | 0 | 0 | 1 | 0 | 1 | 1 | 1 | 1 |
| 1 | 1 | 1 | 1 | 0 | 1 | 0 | 0 | 1 | 0 | 0 | 1 | 1 | 1 |
| 1 | 1 | 1 | 1 | 0 | 1 | 0 | 0 | 1 | 0 | 0 | 0 | 1 | 1 |
| 1 | 1 | 1 | 1 | 0 | 1 | 0 | 0 | 0 | 1 | 0 | 0 | 1 | 1 |
| 1 | 1 | 1 | 1 | 0 | 1 | 0 | 0 | 0 | 1 | 0 | 1 | 1 | 1 |
| 1 | 1 | 1 | 1 | 0 | 1 | 0 | 0 | 0 | 0 | 1 | 0 | 1 | 1 |
| 1 | 1 | 1 | 0 | 1 | 0 | 1 | 0 | 0 | 1 | 0 | 1 | 1 | 0 |
| 1 | 1 | 1 | 0 | 1 | 0 | 1 | 0 | 0 | 0 | 1 | 0 | 1 | 0 |
| 1 | 1 | 1 | 1 | 0 | 1 | 0 | 1 | 1 | 0 | 0 | 0 | 1 | 0 |
| 1 | 1 | 1 | 1 | 0 | 1 | 0 | 1 | 1 | 0 | 1 | 1 | 1 | 0 |
| 1 | 1 | 1 | 1 | 0 | 1 | 0 | 1 | 1 | 0 | 0 | 1 | 1 | 0 |
| 1 | 1 | 1 | 1 | 0 | 1 | 0 | 1 | 1 | 1 | 1 | 1 | 1 | 0 |
| 1 | 1 | 1 | 1 | 0 | 1 | 0 | 1 | 1 | 1 | 1 | 0 | 1 | 0 |
| 1 | 1 | 1 | 0 | 1 | 0 | 0 | 0 | 0 | 0 | 0 | 0 | 0 | 1 |
| 1 | 1 | 1 | 0 | 1 | 0 | 0 | 0 | 0 | 0 | 1 | 1 | 0 | 1 |
| 1 | 1 | 1 | 0 | 1 | 0 | 1 | 0 | 0 | 0 | 0 | 0 | 0 | 1 |
| 1 | 1 | 1 | 0 | 1 | 0 | 1 | 0 | 0 | 1 | 0 | 0 | 0 | 1 |
| 1 | 1 | 1 | 0 | 1 | 0 | 0 | 0 | 0 | 0 | 0 | 1 | 0 | 1 |
| 1 | 1 | 1 | 0 | 1 | 0 | 0 | 0 | 0 | 1 | 1 | 1 | 0 | 1 |
| 1 | 1 | 1 | 0 | 1 | 0 | 0 | 0 | 0 | 1 | 1 | 0 | 0 | 1 |
| 1 | 1 | 1 | 0 | 1 | 0 | 1 | 0 | 1 | 0 | 0 | 1 | 0 | 0 |
| 1 | 1 | 1 | 0 | 1 | 0 | 1 | 0 | 1 | 0 | 0 | 0 | 0 | 0 |
| 1 | 1 | 1 | 0 | 1 | 0 | 0 | 1 | 0 | 1 | 0 | 0 | 0 | 0 |
| 1 | 1 | 1 | 0 | 1 | 0 | 1 | 0 | 1 | 0 | 1 | 1 | 0 | 0 |
| 1 | 1 | 1 | 0 | 1 | 0 | 0 | 1 | 0 | 0 | 0 | 0 | 0 | 0 |
| 1 | 1 | 1 | 0 | 1 | 0 | 0 | 1 | 0 | 1 | 0 | 1 | 0 | 0 |
| 1 | 1 | 1 | 0 | 1 | 0 | 0 | 1 | 0 | 0 | 1 | 0 | 0 | 0 |
| 1 | 1 | 1 | 0 | 0 | 0 | 0 | 0 | 0 | 0 | 0 | 0 | 1 | 1 |
| 1 | 1 | 1 | 0 | 0 | 0 | 0 | 0 | 0 | 1 | 0 | 0 | 1 | 1 |
| 1 | 1 | 1 | 0 | 0 | 0 | 0 | 1 | 1 | 0 | 0 | 0 | 1 | 1 |
| 1 | 1 | 1 | 0 | 0 | 0 | 0 | 1 | 1 | 0 | 1 | 1 | 1 | 1 |
| 1 | 1 | 1 | 0 | 0 | 0 | 0 | 1 | 1 | 0 | 0 | 1 | 1 | 1 |
| 1 | 1 | 1 | 0 | 0 | 0 | 0 | 1 | 1 | 1 | 1 | 1 | 1 | 1 |
| 1 | 1 | 1 | 0 | 0 | 0 | 0 | 1 | 1 | 1 | 1 | 0 | 1 | 1 |
| 1 | 1 | 1 | 1 | 0 | 0 | 1 | 0 | 0 | 0 | 0 | 0 | 1 | 0 |
| 1 | 1 | 1 | 1 | 0 | 0 | 0 | 0 | 0 | 0 | 1 | 1 | 1 | 0 |
| 1 | 1 | 1 | 1 | 0 | 0 | 1 | 0 | 0 | 1 | 0 | 0 | 1 | 0 |
| 1 | 1 | 1 | 1 | 0 | 0 | 0 | 0 | 0 | 0 | 0 | 1 | 1 | 0 |
| 1 | 1 | 1 | 1 | 0 | 0 | 0 | 0 | 0 | 1 | 1 | 1 | 1 | 0 |
| 1 | 1 | 1 | 1 | 0 | 0 | 1 | 0 | 0 | 1 | 0 | 1 | 1 | 0 |
| 1 | 1 | 1 | 1 | 0 | 0 | 1 | 0 | 0 | 0 | 1 | 0 | 1 | 0 |
| 1 | 1 | 1 | 0 | 0 | 0 | 1 | 1 | 1 | 1 | 0 | 0 | 0 | 1 |
| 1 | 1 | 1 | 0 | 0 | 0 | 0 | 0 | 1 | 0 | 1 | 1 | 0 | 1 |
| 1 | 1 | 1 | 0 | 0 | 0 | 1 | 1 | 1 | 1 | 0 | 1 | 0 | 1 |
| 1 | 1 | 1 | 0 | 0 | 0 | 1 | 1 | 1 | 0 | 1 | 0 | 0 | 1 |
| 1 | 1 | 1 | 0 | 0 | 0 | 1 | 1 | 1 | 0 | 0 | 0 | 0 | 1 |
| 1 | 1 | 1 | 0 | 0 | 0 | 0 | 0 | 1 | 0 | 0 | 1 | 0 | 1 |
| 1 | 1 | 1 | 0 | 0 | 0 | 0 | 0 | 1 | 0 | 0 | 0 | 0 | 1 |
| 1 | 1 | 1 | 0 | 0 | 0 | 1 | 1 | 0 | 0 | 0 | 0 | 0 | 0 |
| 1 | 1 | 1 | 0 | 0 | 0 | 1 | 1 | 0 | 0 | 1 | 1 | 0 | 0 |
| 1 | 1 | 1 | 0 | 0 | 0 | 1 | 1 | 0 | 0 | 0 | 1 | 0 | 0 |
| 1 | 1 | 1 | 0 | 0 | 0 | 1 | 1 | 0 | 1 | 1 | 1 | 0 | 0 |
| 1 | 1 | 1 | 0 | 0 | 0 | 1 | 1 | 0 | 1 | 1 | 0 | 0 | 0 |
| 1 | 1 | 1 | 0 | 0 | 0 | 0 | 0 | 0 | 1 | 0 | 1 | 0 | 0 |
| 1 | 1 | 1 | 0 | 0 | 0 | 0 | 0 | 0 | 0 | 1 | 0 | 0 | 0 |
| 1 | 1 | 0 | 0 | 0 | 0 | 1 | 0 | 0 | 0 | 0 | 0 | 1 | 1 |
| 1 | 1 | 0 | 0 | 0 | 0 | 0 | 0 | 0 | 0 | 1 | 1 | 1 | 1 |
| 1 | 1 | 0 | 0 | 0 | 0 | 1 | 0 | 0 | 1 | 0 | 0 | 1 | 1 |
| 1 | 1 | 0 | 0 | 0 | 0 | 0 | 0 | 0 | 0 | 0 | 1 | 1 | 1 |
| 1 | 1 | 0 | 0 | 0 | 0 | 0 | 0 | 0 | 1 | 1 | 1 | 1 | 1 |

Table 4 (continued)

```
1 1 0    0 0 0    1 0 0    1 0 1    1 1
1 1 0    0 0 0    1 0 0    0 1 0    1 1
1 1 0    0 1 1    0 0 0    0 0 0    1 0
1 1 0    0 1 1    0 0 0    1 0 0    1 0
1 1 0    0 1 1    0 1 1    0 0 0    1 0
1 1 0    0 1 1    0 1 1    0 1 1    1 0
1 1 0    0 1 1    0 1 1    0 0 1    1 0
1 1 0    0 1 1    0 1 1    1 1 1    1 0
1 1 0    0 1 1    0 1 1    1 1 0    1 0
1 1 0    0 1 1    1 1 1    1 0 0    0 1
1 1 0    0 1 1    0 0 1    0 1 1    0 1
1 1 0    0 1 1    1 1 1    1 0 1    0 1
1 1 0    0 1 1    1 1 1    0 1 0    0 1
1 1 0    0 1 1    1 1 1    0 0 0    0 1
1 1 0    0 1 1    0 0 1    0 0 1    0 1
1 1 0    0 1 1    0 0 1    0 0 0    0 1
1 1 0    0 1 1    1 1 0    0 0 0    0 0
1 1 0    0 1 1    1 1 0    0 1 1    0 0
1 1 0    0 1 1    1 1 0    0 0 1    0 0
1 1 0    0 1 1    1 1 0    1 1 1    0 0
1 1 0    0 1 1    1 1 0    1 1 0    0 0
1 1 0    0 1 1    0 0 0    1 0 1    0 0
1 1 0    0 1 1    0 0 0    0 1 0    0 0
1 1 0    1 1 1    1 0 0    1 0 1    1 1
1 1 0    1 1 1    1 0 0    0 1 0    1 1
1 1 0    0 0 1    0 1 1    0 0 0    1 1
1 1 0    0 0 1    0 1 1    0 1 1    1 1
1 1 0    0 0 1    0 1 1    0 0 1    1 1
1 1 0    0 0 1    0 1 1    1 1 1    1 1
1 1 0    0 0 1    0 1 1    1 1 0    1 1
1 1 0    1 1 1    1 0 1    0 0 1    1 0
1 1 0    1 1 1    1 0 1    0 0 0    1 0
1 1 0    1 1 1    0 1 0    1 0 0    1 0
1 1 0    1 1 1    1 0 1    0 1 1    1 0
1 1 0    1 1 1    0 1 0    0 0 0    1 0
1 1 0    1 1 1    0 1 0    1 0 1    1 0
1 1 0    1 1 1    0 1 0    0 1 0    1 0
1 1 0    1 1 1    0 0 0    0 0 0    0 1
1 1 0    1 1 1    0 0 0    0 1 1    0 1
1 1 0    1 1 1    1 0 0    0 0 0    0 1
1 1 0    1 1 1    1 0 0    1 0 0    0 1
1 1 0    1 1 1    0 0 0    0 0 1    0 1
1 1 0    1 1 1    0 0 0    1 1 1    0 1
1 1 0    1 1 1    0 0 0    1 1 0    0 1
1 1 0    0 0 1    0 0 0    0 0 0    0 0
1 1 0    0 0 1    0 0 1    0 1 1    0 0
1 1 0    0 0 1    0 0 1    0 0 1    0 0
1 1 0    0 0 1    0 0 1    0 0 0    0 0
1 1 0    0 0 1    0 0 0    1 0 0    0 0
1 1 0    0 0 1    0 0 0    1 0 1    0 0
1 1 0    0 0 1    0 0 0    0 1 0    0 0
1 1 0    1 1 0    0 0 0    0 0 0    1 1
1 1 0    1 1 0    0 0 0    1 0 0    1 1
1 1 0    1 1 0    0 1 1    0 0 0    1 1
1 1 0    1 1 0    0 1 1    0 1 1    1 1
1 1 0    1 1 0    0 1 1    0 0 1    1 1
1 1 0    1 1 0    0 1 1    1 1 1    1 1
1 1 0    1 1 0    0 1 1    1 1 0    1 1
1 1 0    1 1 0    1 1 1    1 0 0    1 0
1 1 0    1 1 0    0 0 1    0 1 1    1 0
```

Table 4 (continued)

| | | | | |
|---|---|---|---|---|
| 1 1 0 | 1 1 0 | 1 1 1 | 1 0 1 | 1 0 |
| 1 1 0 | 1 1 0 | 1 1 1 | 0 1 0 | 1 0 |
| 1 1 0 | 1 1 0 | 1 1 1 | 0 0 0 | 1 0 |
| 1 1 0 | 1 1 0 | 0 0 1 | 0 0 1 | 1 0 |
| 1 1 0 | 1 1 0 | 0 0 1 | 0 0 0 | 1 0 |
| 1 1 0 | 1 1 0 | 1 1 0 | 0 0 0 | 0 1 |
| 1 1 0 | 1 1 0 | 1 1 0 | 0 1 1 | 0 1 |
| 1 1 0 | 1 1 0 | 1 1 0 | 0 0 1 | 0 1 |
| 1 1 0 | 1 1 0 | 1 1 0 | 1 1 1 | 0 1 |
| 1 1 0 | 1 1 0 | 1 1 0 | 1 1 0 | 0 1 |
| 1 1 0 | 1 1 0 | 0 0 0 | 1 0 1 | 0 1 |
| 1 1 0 | 1 1 0 | 0 0 0 | 0 1 0 | 0 1 |
| 1 1 0 | 0 0 0 | 1 0 1 | 0 0 1 | 0 0 |
| 1 1 0 | 0 0 0 | 1 0 1 | 0 0 0 | 0 0 |
| 1 1 0 | 0 0 0 | 0 1 0 | 1 0 0 | 0 0 |
| 1 1 0 | 0 0 0 | 1 0 1 | 0 1 1 | 0 0 |
| 1 1 0 | 0 0 0 | 0 1 0 | 0 0 0 | 0 0 |
| 1 1 0 | 0 0 0 | 0 1 0 | 1 0 1 | 0 0 |
| 1 1 0 | 0 0 0 | 0 1 0 | 0 1 0 | 0 0 |
| 1 0 1 | 0 0 0 | 0 0 0 | 1 1 0 | 1 1 |
| 1 0 1 | 0 0 0 | 0 0 0 | 0 0 0 | 1 1 |
| 1 0 1 | 0 0 1 | 0 1 1 | 0 0 0 | 1 1 |
| 1 0 1 | 0 0 1 | 0 1 1 | 0 1 1 | 1 1 |
| 1 0 1 | 0 0 1 | 0 1 1 | 0 0 1 | 1 1 |
| 1 0 1 | 0 0 1 | 0 1 1 | 1 1 1 | 1 1 |
| 1 0 1 | 0 0 1 | 0 1 1 | 1 1 0 | 1 1 |
| 1 0 1 | 0 0 1 | 0 0 0 | 0 0 0 | 1 0 |
| 1 0 1 | 0 0 1 | 0 0 1 | 0 1 1 | 1 0 |
| 1 0 1 | 0 0 1 | 0 0 1 | 0 0 1 | 1 0 |
| 1 0 1 | 0 0 1 | 0 0 1 | 0 0 0 | 1 0 |
| 1 0 1 | 0 0 1 | 0 0 0 | 1 0 0 | 1 0 |
| 1 0 1 | 0 0 1 | 0 0 0 | 1 0 1 | 1 0 |
| 1 0 1 | 0 0 1 | 0 0 0 | 0 1 0 | 1 0 |
| 1 0 1 | 0 0 0 | 1 0 0 | 0 0 0 | 0 1 |
| 1 0 1 | 0 0 0 | 0 0 0 | 0 1 1 | 0 1 |
| 1 0 1 | 0 0 0 | 1 0 0 | 1 0 0 | 0 1 |
| 1 0 1 | 0 0 0 | 0 0 0 | 0 0 1 | 0 1 |
| 1 0 1 | 0 0 0 | 0 0 0 | 1 1 1 | 0 1 |
| 1 0 1 | 0 0 0 | 1 0 0 | 1 0 1 | 0 1 |
| 1 0 1 | 0 0 0 | 1 0 0 | 0 1 0 | 0 1 |
| 1 0 1 | 0 0 0 | 1 0 1 | 0 0 1 | 0 0 |
| 1 0 1 | 0 0 0 | 1 0 1 | 0 0 0 | 0 0 |
| 1 0 1 | 0 0 0 | 0 1 0 | 1 0 0 | 0 0 |
| 1 0 1 | 0 0 0 | 1 0 1 | 0 1 1 | 0 0 |
| 1 0 1 | 0 0 0 | 0 1 0 | 0 0 0 | 0 0 |
| 1 0 1 | 0 0 0 | 0 1 0 | 1 0 1 | 0 0 |
| 1 0 1 | 0 0 0 | 0 1 0 | 0 1 0 | 0 0 |
| 0 1 0 | 1 0 0 | 1 0 1 | 0 0 1 | 1 1 |
| 0 1 0 | 1 0 0 | 1 0 1 | 0 0 0 | 1 1 |
| 0 1 0 | 1 0 0 | 0 1 0 | 1 0 0 | 1 1 |
| 0 1 0 | 1 0 0 | 1 0 1 | 0 1 1 | 1 1 |
| 0 1 0 | 1 0 0 | 0 1 0 | 0 0 0 | 1 1 |
| 0 1 0 | 1 0 0 | 0 1 0 | 1 0 1 | 1 1 |
| 0 1 0 | 1 0 0 | 0 1 0 | 0 1 0 | 1 1 |
| 1 0 1 | 0 1 1 | 0 0 0 | 0 0 0 | 1 0 |
| 1 0 1 | 0 1 1 | 0 0 0 | 1 0 0 | 1 0 |
| 1 0 1 | 0 1 1 | 0 1 1 | 0 0 0 | 1 0 |
| 1 0 1 | 0 1 1 | 0 1 1 | 0 1 1 | 1 0 |
| 1 0 1 | 0 1 1 | 0 1 1 | 0 0 1 | 1 0 |
| 1 0 1 | 0 1 1 | 0 1 1 | 1 1 1 | 1 0 |

Table 4 (continued)

```
1 0 1   0 1 1   0 1 1   1 1 0   1 0
1 0 1   0 1 1   1 1 1   1 0 0   0 1
1 0 1   0 1 1   0 0 1   0 1 1   0 1
1 0 1   0 1 1   1 1 1   1 0 1   0 1
1 0 1   0 1 1   1 1 1   0 1 0   0 1
1 0 1   0 1 1   1 1 1   0 0 0   0 1
1 0 1   0 1 1   0 0 1   0 0 1   0 1
1 0 1   0 1 1   0 0 1   0 0 0   0 1
1 0 1   0 1 1   1 1 0   0 0 0   0 0
1 0 1   0 1 1   1 1 0   0 1 1   0 0
1 0 1   0 1 1   1 1 0   0 0 1   0 0
1 0 1   0 1 1   1 1 0   1 1 1   0 0
1 0 1   0 1 1   1 1 0   1 1 0   0 0
1 0 1   0 1 1   0 0 0   1 0 1   0 0
1 0 1   0 1 1   0 0 0   0 1 0   0 0
0 1 0   0 0 0   0 0 0   0 0 0   1 1
0 1 0   0 0 0   0 0 0   1 0 0   1 1
0 1 0   0 0 0   0 1 1   0 0 0   1 1
0 1 0   0 0 0   0 1 1   0 1 1   1 1
0 1 0   0 0 0   0 1 1   0 0 1   1 1
0 1 0   0 0 0   0 1 1   1 1 1   1 1
0 1 0   0 0 0   0 1 1   1 1 0   1 1
0 1 0   1 0 0   1 0 0   0 0 0   1 0
0 1 0   1 0 0   0 0 0   0 1 1   1 0
0 1 0   1 0 0   1 0 0   1 0 0   1 0
0 1 0   1 0 0   0 0 0   0 0 1   1 0
0 1 0   1 0 0   0 0 0   1 1 1   1 0
0 1 0   1 0 0   1 0 0   1 0 1   1 0
0 1 0   1 0 0   1 0 0   0 1 0   1 0
0 1 0   0 0 0   1 1 1   1 0 0   0 1
0 1 0   0 0 0   0 0 1   0 1 1   0 1
0 1 0   0 0 0   1 1 1   1 0 1   0 1
0 1 0   0 0 0   1 1 1   0 1 0   0 1
0 1 0   0 0 0   1 1 1   0 0 0   0 1
0 1 0   0 0 0   0 0 1   0 0 1   0 1
0 1 0   0 0 0   0 0 1   0 0 0   0 1
0 1 0   0 0 0   1 1 0   0 0 0   0 0
0 1 0   0 0 0   1 1 0   0 1 1   0 0
0 1 0   0 0 0   1 1 0   0 0 1   0 0
0 1 0   0 0 0   1 1 0   1 1 1   0 0
0 1 0   0 0 0   1 1 0   1 1 0   0 0
0 1 0   0 0 0   0 0 0   1 0 1   0 0
0 1 0   0 0 0   0 0 0   0 1 0   0 0
0 1 0   1 0 1   0 0 0   0 0 0   1 1
0 1 0   1 0 1   0 0 1   0 1 1   1 1
0 1 0   1 0 1   0 0 1   0 0 1   1 1
0 1 0   1 0 1   0 0 1   0 0 0   1 1
0 1 0   1 0 1   0 0 0   1 0 0   1 1
0 1 0   1 0 1   0 0 0   1 0 1   1 1
0 1 0   1 0 1   0 0 0   0 1 0   1 1
0 1 0   0 1 0   1 0 0   1 0 1   1 0
0 1 0   0 1 0   1 0 0   0 1 0   1 0
0 1 0   1 0 1   0 1 1   0 0 0   1 0
0 1 0   1 0 1   0 1 1   0 1 1   1 0
0 1 0   1 0 1   0 1 1   0 0 1   1 0
0 1 0   1 0 1   0 1 1   1 1 1   1 0
0 1 0   1 0 1   0 1 1   1 1 0   1 0
0 1 0   0 1 0   0 0 0   0 0 0   0 1
0 1 0   0 1 0   0 0 0   0 1 1   0 1
0 1 0   0 1 0   1 0 0   0 0 0   0 1
```

Table 4 (continued)

```
0 1 0    0 1 0    1 0 0    1 0 0    0 1
0 1 0    0 1 0    0 0 0    0 0 1    0 1
0 1 0    0 1 0    0 0 0    1 1 1    0 1
0 1 0    0 1 0    0 0 0    1 1 0    0 1
0 1 0    0 1 0    1 0 1    0 0 1    0 0
0 1 0    0 1 0    1 0 1    0 0 0    0 0
0 1 0    0 1 0    0 1 0    1 0 0    0 0
0 1 0    0 1 0    1 0 1    0 1 1    0 0
0 1 0    0 1 0    0 1 0    0 0 0    0 0
0 1 0    0 1 0    0 1 0    1 0 1    0 0
0 1 0    0 1 0    0 1 0    0 1 0    0 0
0 0 0    0 0 0    0 0 0    1 1 1    1 1
0 0 0    0 0 0    0 0 0    1 1 0    1 1
0 0 0    0 0 0    1 0 0    0 0 0    1 1
0 0 0    0 0 0    0 0 0    0 1 1    1 1
0 0 0    0 0 0    1 0 0    1 0 0    1 1
0 0 0    0 0 0    1 0 0    1 0 1    1 1
0 0 0    0 0 0    1 0 0    0 1 0    1 1
1 0 0    1 0 0    0 0 0    1 1 0    1 1
1 0 0    1 0 0    0 0 0    0 0 0    1 1
1 0 0    0 0 0    0 1 1    0 0 0    1 1
1 0 0    0 0 0    0 1 1    0 1 1    1 1
1 0 0    0 0 0    0 1 1    0 0 1    1 1
1 0 0    0 0 0    0 1 1    1 1 1    1 1
1 0 0    0 0 0    0 1 1    1 1 0    1 1
1 0 0    1 0 0    1 0 0    0 0 0    1 0
1 0 0    1 0 0    0 0 0    0 1 1    1 0
1 0 0    1 0 0    1 0 0    1 0 0    1 0
1 0 0    1 0 0    0 0 0    0 0 1    1 0
1 0 0    1 0 0    0 0 0    1 1 1    1 0
1 0 0    1 0 0    1 0 0    1 0 1    1 0
1 0 0    1 0 0    1 0 0    0 1 0    1 0
1 0 0    0 0 0    1 1 1    1 0 0    0 1
1 0 0    0 0 0    0 0 1    0 1 1    0 1
1 0 0    0 0 0    1 1 1    1 0 1    0 1
1 0 0    0 0 0    1 1 1    0 1 0    0 1
1 0 0    0 0 0    1 1 1    0 0 0    0 1
1 0 0    0 0 0    0 0 1    0 0 1    0 1
1 0 0    0 0 0    0 0 1    0 0 0    0 1
1 0 0    1 0 0    1 0 1    0 0 1    0 0
1 0 0    1 0 0    1 0 1    0 0 0    0 0
1 0 0    1 0 0    0 1 0    1 0 0    0 0
1 0 0    1 0 0    1 0 1    0 1 1    0 0
1 0 0    1 0 0    0 1 0    0 0 0    0 0
1 0 0    1 0 0    0 1 0    1 0 1    0 0
1 0 0    1 0 0    0 1 0    0 1 0    0 0
0 0 0    1 1 1    1 0 0    1 0 1    1 1
0 0 0    1 1 1    1 0 0    0 1 0    1 1
0 0 0    0 0 1    0 1 1    0 0 0    1 1
0 0 0    0 0 1    0 1 1    0 1 1    1 1
0 0 0    0 0 1    0 1 1    0 0 1    1 1
0 0 0    0 0 1    0 1 1    1 1 1    1 1
0 0 0    0 0 1    0 1 1    1 1 0    1 1
0 0 0    0 0 1    0 0 0    0 0 0    1 0
0 0 0    0 0 1    0 0 1    0 1 1    1 0
0 0 0    0 0 1    0 0 1    0 0 1    1 0
0 0 0    0 0 1    0 0 1    0 0 0    1 0
0 0 0    0 0 1    0 0 0    1 0 0    1 0
0 0 0    0 0 1    0 0 0    1 0 1    1 0
0 0 0    0 0 1    0 0 0    0 1 0    1 0
```

Table 4 (continued)

| | | | | |
|---|---|---|---|---|
| 0 0 0 | 1 1 0 | 1 1 0 | 0 0 0 | 0 1 |
| 0 0 0 | 1 1 0 | 1 1 0 | 0 1 1 | 0 1 |
| 0 0 0 | 1 1 0 | 1 1 0 | 0 0 1 | 0 1 |
| 0 0 0 | 1 1 0 | 1 1 0 | 1 1 1 | 0 1 |
| 0 0 0 | 1 1 0 | 1 1 0 | 1 1 0 | 0 1 |
| 0 0 0 | 1 1 0 | 0 0 0 | 1 0 1 | 0 1 |
| 0 0 0 | 1 1 0 | 0 0 0 | 0 1 0 | 0 1 |
| 0 0 0 | 0 0 0 | 1 0 1 | 0 0 1 | 0 0 |
| 0 0 0 | 0 0 0 | 1 0 1 | 0 0 0 | 0 0 |
| 0 0 0 | 0 0 0 | 0 1 0 | 1 0 0 | 0 0 |
| 0 0 0 | 0 0 0 | 1 0 1 | 0 1 1 | 0 0 |
| 0 0 0 | 0 0 0 | 0 1 0 | 0 0 0 | 0 0 |
| 0 0 0 | 0 0 0 | 0 1 0 | 1 0 1 | 0 0 |
| 0 0 0 | 0 0 0 | 0 1 0 | 0 1 0 | 0 0 |
| 1 0 0 | 1 0 1 | 0 0 0 | 0 0 0 | 1 1 |
| 1 0 0 | 1 0 1 | 0 0 1 | 0 1 1 | 1 1 |
| 1 0 0 | 1 0 1 | 0 0 1 | 0 0 1 | 1 1 |
| 1 0 0 | 1 0 1 | 0 0 1 | 0 0 0 | 1 1 |
| 1 0 0 | 1 0 1 | 0 0 0 | 1 0 0 | 1 1 |
| 1 0 0 | 1 0 1 | 0 0 0 | 1 0 1 | 1 1 |
| 1 0 0 | 1 0 1 | 0 0 0 | 0 1 0 | 1 1 |
| 1 0 0 | 0 1 0 | 1 0 0 | 1 0 1 | 1 0 |
| 1 0 0 | 0 1 0 | 1 0 0 | 0 1 0 | 1 0 |
| 1 0 0 | 1 0 1 | 0 1 1 | 0 0 0 | 1 0 |
| 1 0 0 | 1 0 1 | 0 1 1 | 0 1 1 | 1 0 |
| 1 0 0 | 1 0 1 | 0 1 1 | 0 0 1 | 1 0 |
| 1 0 0 | 1 0 1 | 0 1 1 | 1 1 1 | 1 0 |
| 1 0 0 | 1 0 1 | 0 1 1 | 1 1 0 | 1 0 |
| 1 0 0 | 0 1 0 | 0 0 0 | 0 0 0 | 0 1 |
| 1 0 0 | 0 1 0 | 0 0 0 | 0 1 1 | 0 1 |
| 1 0 0 | 0 1 0 | 1 0 0 | 0 0 0 | 0 1 |
| 1 0 0 | 0 1 0 | 1 0 0 | 1 0 0 | 0 1 |
| 1 0 0 | 0 1 0 | 0 0 0 | 0 0 1 | 0 1 |
| 1 0 0 | 0 1 0 | 0 0 0 | 1 1 1 | 0 1 |
| 1 0 0 | 0 1 0 | 0 0 0 | 1 1 0 | 0 1 |
| 1 0 0 | 0 1 0 | 1 0 1 | 0 0 1 | 0 0 |
| 1 0 0 | 0 1 0 | 1 0 1 | 0 0 0 | 0 0 |
| 1 0 0 | 0 1 0 | 0 1 0 | 1 0 0 | 0 0 |
| 1 0 0 | 0 1 0 | 1 0 1 | 0 1 1 | 0 0 |
| 1 0 0 | 0 1 0 | 0 1 0 | 0 0 0 | 0 0 |
| 1 0 0 | 0 1 0 | 0 1 0 | 1 0 1 | 0 0 |
| 1 0 0 | 0 1 0 | 0 1 0 | 0 1 0 | 0 0 |
| 0 0 0 | 0 0 0 | 1 1 0 | 1 1 0 | 1 1 |
| 0 0 0 | 0 0 0 | 0 0 0 | 1 0 1 | 1 1 |
| 0 0 0 | 0 0 0 | 0 0 0 | 0 1 0 | 1 1 |
| 0 0 1 | 0 0 0 | 0 0 0 | 1 1 0 | 1 1 |
| 0 0 1 | 0 0 0 | 0 0 0 | 0 0 0 | 1 1 |
| 0 0 1 | 0 0 1 | 0 1 1 | 0 0 0 | 1 1 |
| 0 0 1 | 0 0 1 | 0 1 1 | 0 1 1 | 1 1 |
| 0 0 1 | 0 0 1 | 0 1 1 | 0 0 1 | 1 1 |
| 0 0 1 | 0 0 1 | 0 1 1 | 1 1 1 | 1 1 |
| 0 0 1 | 0 0 1 | 0 1 1 | 1 1 0 | 1 1 |
| 0 0 1 | 0 0 1 | 0 0 0 | 0 0 0 | 1 0 |
| 0 0 1 | 0 0 1 | 0 0 1 | 0 1 1 | 1 0 |
| 0 0 1 | 0 0 1 | 0 0 1 | 0 0 1 | 1 0 |
| 0 0 1 | 0 0 1 | 0 0 1 | 0 0 0 | 1 0 |
| 0 0 1 | 0 0 1 | 0 0 0 | 1 0 0 | 1 0 |
| 0 0 1 | 0 0 1 | 0 0 0 | 1 0 1 | 1 0 |
| 0 0 1 | 0 0 1 | 0 0 0 | 0 1 0 | 1 0 |
| 0 0 1 | 0 0 0 | 1 0 0 | 0 0 0 | 0 1 |

Table 4 (continued)

```
0 0 1    0 0 0    0 0 0    0 1 1    0 1
0 0 1    0 0 0    1 0 0    1 0 0    0 1
0 0 1    0 0 0    0 0 0    0 0 1    0 1
0 0 1    0 0 0    0 0 0    1 1 1    0 1
0 0 1    0 0 0    1 0 0    1 0 1    0 1
0 0 1    0 0 0    1 0 0    0 1 0    0 1
0 0 1    0 0 0    1 0 1    0 0 1    0 0
0 0 1    0 0 0    1 0 1    0 0 0    0 0
0 0 1    0 0 0    0 1 0    1 0 0    0 0
0 0 1    0 0 0    1 0 1    0 1 1    0 0
0 0 1    0 0 0    0 1 0    0 0 0    0 0
0 0 1    0 0 0    1 0 1    1 0 1    0 0
0 0 1    0 0 0    0 1 0    0 1 0    0 0
0 0 0    0 0 0    0 0 1    0 1 1    1 1
0 0 0    0 0 0    0 0 1    0 0 1    1 1
0 0 0    0 0 0    0 0 1    0 0 0    1 1
0 0 0    1 0 1    0 0 0    0 0 0    1 1
0 0 0    1 0 1    0 0 1    0 1 1    1 1
0 0 0    1 0 1    0 0 1    0 0 1    1 1
0 0 0    1 0 1    0 0 1    0 0 0    1 1
0 0 0    1 0 1    0 0 0    1 0 0    1 1
0 0 0    1 0 1    0 0 0    1 0 1    1 1
0 0 0    1 0 1    0 0 0    0 1 0    1 1
0 0 0    0 1 0    1 0 0    1 0 1    1 0
0 0 0    0 1 0    1 0 0    0 1 0    1 0
0 0 0    1 0 1    0 1 1    0 0 0    1 0
0 0 0    1 0 1    0 1 1    0 1 1    1 0
0 0 0    1 0 1    0 1 1    0 0 1    1 0
0 0 0    1 0 1    0 1 1    1 1 1    1 0
0 0 0    1 0 1    0 1 1    1 1 0    1 0
0 0 0    0 1 0    0 0 0    0 0 0    0 1
0 0 0    0 1 0    0 0 0    0 1 1    0 1
0 0 0    0 1 0    1 0 0    0 0 0    0 1
0 0 0    0 1 0    1 0 0    1 0 0    0 1
0 0 0    0 1 0    0 0 0    0 0 1    0 1
0 0 0    0 1 0    0 0 0    1 1 1    0 1
0 0 0    0 1 0    1 0 1    0 0 1    0 0
0 0 0    0 1 0    1 0 1    0 0 0    0 0
0 0 0    0 1 0    0 1 0    1 0 0    0 0
0 0 0    0 1 0    1 0 1    0 1 1    0 0
0 0 0    0 1 0    0 1 0    0 0 0    0 0
0 0 0    0 1 0    0 1 0    1 0 1    0 0
0 0 0    0 1 0    0 1 0    0 1 0    0 0
0 1 1    0 0 0    1 0 0    0 0 0    1 1
0 1 1    0 0 0    0 0 0    0 1 1    1 1
0 1 1    0 0 0    1 0 0    1 0 0    1 1
0 1 1    0 0 0    0 0 0    0 0 1    1 1
0 1 1    0 0 0    0 0 0    1 1 1    1 1
0 1 1    0 0 0    1 0 0    1 0 1    1 1
0 1 1    0 0 0    1 0 0    0 1 0    1 1
0 1 1    0 1 1    0 0 0    0 0 0    1 0
0 1 1    0 1 1    0 0 0    1 0 0    1 0
0 1 1    0 1 1    0 1 1    0 0 0    1 0
0 1 1    0 1 1    0 1 1    0 1 1    1 0
0 1 1    0 1 1    0 1 1    0 0 1    1 0
0 1 1    0 1 1    0 1 1    1 1 1    1 0
0 1 1    0 1 1    1 1 1    1 0 0    0 1
0 1 1    0 1 1    0 0 1    0 1 1    0 1
```

16

Table 4 (continued)

```
0 1 1    0 1 1    1 1 1    1 0 1    0 1
0 1 1    0 1 1    1 1 1    0 1 0    0 1
0 1 1    0 1 1    1 1 1    0 0 0    0 1
0 1 1    0 1 1    0 0 1    0 0 1    0 1
0 1 1    0 1 1    0 0 1    0 0 0    0 1
0 1 1    0 1 1    1 1 0    0 0 0    0 0
0 1 1    0 1 1    1 1 0    0 1 1    0 0
0 1 1    0 1 1    1 1 0    0 0 1    0 0
0 1 1    0 1 1    1 1 0    1 1 1    0 0
0 1 1    0 1 1    1 1 0    1 1 0    0 0
0 1 1    0 1 1    0 0 0    1 0 1    0 0
0 1 1    0 1 1    0 0 0    0 1 0    0 0
0 1 1    1 1 1    1 0 0    1 0 1    1 1
0 1 1    1 1 1    1 0 0    0 1 0    1 1
0 1 1    0 0 1    0 1 1    0 0 0    1 1
0 1 1    0 0 1    0 1 1    0 1 1    1 1
0 1 1    0 0 1    0 1 1    0 0 1    1 1
0 1 1    0 0 1    0 1 1    1 1 1    1 1
0 1 1    0 0 1    0 1 1    1 1 0    1 1
0 1 1    1 1 1    1 0 1    0 0 1    1 0
0 1 1    1 1 1    1 0 1    0 0 0    1 0
0 1 1    1 1 1    0 1 0    1 0 0    1 0
0 1 1    1 1 1    1 0 1    0 1 1    1 0
0 1 1    1 1 1    0 1 0    0 0 0    1 0
0 1 1    1 1 1    0 1 0    1 0 1    1 0
0 1 1    1 1 1    0 1 0    0 1 0    1 0
0 1 1    1 1 1    0 0 0    0 0 0    0 1
0 1 1    1 1 1    0 0 0    0 1 1    0 1
0 1 1    1 1 1    1 0 0    0 0 0    0 1
0 1 1    1 1 1    1 0 0    1 0 0    0 1
0 1 1    1 1 1    0 0 0    0 0 1    0 1
0 1 1    1 1 1    0 0 0    1 1 1    0 1
0 1 1    1 1 1    0 0 0    1 1 0    0 1
0 1 1    0 0 1    0 0 0    0 0 0    0 0
0 1 1    0 0 1    0 0 1    0 1 1    0 0
0 1 1    0 0 1    0 0 1    0 0 1    0 0
0 1 1    0 0 1    0 0 1    0 0 0    0 0
0 1 1    0 0 1    0 0 0    1 0 0    0 0
0 1 1    0 0 1    0 0 0    1 0 1    0 0
0 1 1    0 0 1    0 0 0    0 1 0    0 0
0 1 1    1 1 0    0 0 0    0 0 0    1 1
0 1 1    1 1 0    0 0 0    1 0 0    1 1
0 1 1    1 1 0    0 1 1    0 0 0    1 1
0 1 1    1 1 0    0 1 1    0 1 1    1 1
0 1 1    1 1 0    0 1 1    0 0 1    1 1
0 1 1    1 1 0    0 1 1    1 1 1    1 1
0 1 1    1 1 0    0 1 1    1 1 0    1 1
0 1 1    1 1 0    1 1 1    1 0 0    1 0
0 1 1    1 1 0    0 0 1    0 1 1    1 0
0 1 1    1 1 0    1 1 1    1 0 1    1 0
0 1 1    1 1 0    1 1 1    0 1 0    1 0
0 1 1    1 1 0    1 1 1    0 0 0    1 0
0 1 1    1 1 0    0 0 1    0 0 1    1 0
0 1 1    1 1 0    0 0 1    0 0 0    1 0
0 1 1    1 1 0    1 1 0    0 0 0    0 1
0 1 1    1 1 0    1 1 0    0 1 1    0 1
0 1 1    1 1 0    1 1 0    0 0 1    0 1
0 1 1    1 1 0    1 1 0    1 1 1    0 1
0 1 1    1 1 0    1 1 0    1 1 0    0 1
0 1 1    1 1 0    0 0 0    1 0 1    0 1
```

Table 2. (continued)

| | | | |
|---|---|---|---|
| 00 | 01101 | 01101 | 00010 |
| 01 | 01101 | 01110 | 00010 |
| 10 | 01101 | 01111 | 00010 |
| 11 | 01101 | 10000 | 00010 |
| 00 | 01110 | 01001 | 00010 |
| 01 | 01110 | 01010 | 00010 |
| 10 | 01110 | 01011 | 00010 |
| 11 | 01110 | 01100 | 00010 |
| 00 | 01111 | 00001 | 01001 |
| 01 | 01111 | 00010 | 01001 |
| 10 | 01111 | 00011 | 01001 |
| 11 | 01111 | 01000 | 00010 |
| 00 | 10000 | 00100 | 01001 |
| 01 | 10000 | 00101 | 01001 |
| 10 | 10000 | 00110 | 01001 |
| 11 | 10000 | 00111 | 01001 |
| 00 | 10001 | 00100 | 10000 |
| 01 | 10001 | 10001 | 10000 |
| 10 | 10001 | 10010 | 10000 |
| 11 | 10001 | 10011 | 10000 |
| 00 | 10010 | 00110 | 10000 |
| 01 | 10010 | 10100 | 10000 |
| 10 | 10010 | 10101 | 10000 |
| 11 | 10010 | 10110 | 10000 |
| 00 | 10011 | 00001 | 10000 |
| 01 | 10011 | 00010 | 10000 |
| 10 | 10011 | 00011 | 10000 |
| 11 | 10011 | 00101 | 10000 |
| 00 | 10100 | 01001 | 10010 |
| 01 | 10100 | 01010 | 10010 |
| 10 | 10100 | 01011 | 10010 |
| 11 | 10100 | 01100 | 10010 |
| 00 | 10101 | 01101 | 10010 |
| 01 | 10101 | 01110 | 10010 |
| 10 | 10101 | 01111 | 10010 |
| 11 | 10101 | 10000 | 10010 |
| 00 | 10110 | 00001 | 00001 |
| 01 | 10110 | 00010 | 00001 |
| 10 | 10110 | 00011 | 00001 |
| 11 | 10110 | 01000 | 10010 |
| 00 | 10111 | 00001 | 00000 |
| 01 | 10111 | 00010 | 00000 |
| 10 | 10111 | 00011 | 00000 |
| 11 | 10111 | 01001 | 01000 |
| 00 | 11000 | 01000 | 00000 |
| 01 | 11000 | 01011 | 00000 |
| 10 | 11000 | 10111 | 00000 |
| 11 | 11000 | 11001 | 00000 |

Table 4 (continued)

```
0 1 1    1 1 0    0 0 0    0 1 0    0 1
0 1 1    0 0 0    1 0 1    0 0 1    0 0
0 1 1    0 0 0    1 0 1    0 0 0    0 0
0 1 1    0 0 0    0 1 0    1 0 0    0 0
0 1 1    0 0 0    1 0 1    0 1 1    0 0
0 1 1    0 0 0    0 1 0    0 0 0    0 0
0 1 1    0 0 0    0 1 0    1 0 1    0 0
0 1 1    0 0 0    0 1 0    0 1 0    0 0
```

**Claims**

1.  An encoder (11) for converting binary input data to binary code data that satisfies a (2,18,2) constraint, said encoder comprising:

    means (20) to receive two sequential input bits and a five-bit state vector derived from an immediately preceding encoding operation; and

    means (21) for generating a five-bit codeword and a new five-bit state vector based on said two input bits and five-bit state vector;

    said five-bit codeword being chosen from one of the following eight possible codewords: 00000, 00001, 00010, 00100, 01000, 10000, 10010, 01001.

2.  The encoder of claim 1, wherein the encoder comprises a finite state machine having 25 states.

3.  The encoder of claim 1 or 2, wherein the finite state machine has the following states and paths between states for converting the binary input data into a string of serial (2,18,2) binary code data in which the two sequentially chosen input bits are 00, 01, 10 or 11 and the hyphenated sequences include the next state and five-bit codeword

| Current State | INPUT DATA | | | |
|---|---|---|---|---|
| | 00 | 01 | 10 | 11 |
| 01 | 04-00100 | 17-00100 | 18-00100 | 19-00100 |
| 02 | 06-00100 | 20-00100 | 21-00100 | 22-00100 |
| 03 | 01-00100 | 02-00100 | 03-00100 | 05-00100 |
| 04 | 13-00000 | 14-00000 | 15-00000 | 16-00000 |
| 05 | 08-00000 | 11-00000 | 23-00000 | 10-00000 |
| 06 | 04-00001 | 05-00001 | 06-00001 | 07-00001 |
| 07 | 01-00001 | 02-00001 | 03-00001 | 09-00000 |
| 08 | 13-01000 | 14-01000 | 15-01000 | 16-01000 |
| 09 | 04-00000 | 17-00000 | 18-00000 | 19-00000 |

| | | | | |
|---|---|---|---|---|
| 10 | 20-00000 | 21-00000 | 06-00000 | 22-00000 |
| 11 | 08-01000 | 10-01000 | 11-01000 | 23-01000 |
| 12 | 01-00000 | 02-00000 | 03-00000 | 24-00000 |
| 13 | 13-00010 | 14-00010 | 15-00010 | 16-00010 |
| 14 | 09-00010 | 10-00010 | 11-00010 | 12-00010 |
| 15 | 01-01001 | 02-01001 | 03-01001 | 08-00010 |
| 16 | 04-01001 | 05-01001 | 06-01001 | 07-01001 |
| 17 | 04-10000 | 17-10000 | 18-10000 | 19-10000 |
| 18 | 06-10000 | 20-10000 | 21-10000 | 22-10000 |
| 19 | 01-10000 | 02-10000 | 03-10000 | 05-10000 |
| 20 | 09-10010 | 10-10010 | 11-10010 | 12-10010 |
| 21 | 13-10010 | 14-10010 | 15-10010 | 16-10010 |
| 22 | 01-00001 | 02-00001 | 03-00001 | 08-10010 |
| 23 | 01-00000 | 02-00000 | 03-00000 | 09-01000 |
| 24 | 08-00000 | 11-00000 | 23-00000 | 25-00000 |
| 25 | 20-00000 | 21-00000 | 18-00000 | 19-00000 |

4. A decoder (16) for converting a string of serial rate 2/5 code data to serial binary data comprising:

   means (31) for converting the serial string to 4 5-bit codewords;

   means (32) for converting each 5-bit codeword into a reassigned 3-bit codeword representation;

   means (33) for collecting sets of 4 adjacent 3-bit codeword representations;

   means (34) for converting each reassigned codeword representation to a 2-bit output corresponding to a then current set of 4 3-bit codeword representations; and

   means (35,36,37,38) for converting successive 2-bit output into the serial binary data.

5. The decoder of claim 4, wherein said means for converting said reassigned codeword representations is a look-up table in which the inputs are reduced from 20 to 12 bits as a result of the conversion from five-bit codewords to three-bit codeword representations.

6. Apparatus for converting serial binary input data to serial binary code data that satisfies a (2,18,2) constraint and reconverting it to the serial binary input data, said apparatus comprising:

   encoder means as claimed in any of claims 1 to 3; and

   decoder means as claimed in claim 4 or 5.

7. A method of encoding binary input data into binary code data that satisfies a (2,18,2) constraint, comprising the steps of:

   converting binary input data into sequential sets of two input bits;

   deriving from an immediately preceding encoding operation a five-bit state vector;

   providing eight possible codewords: 00000, 00001, 00010, 00100, 01000, 10000, 01001; and

   from said two input bits and five-bit state vector, generating an appropriate one of said possible five-bit codewords.

8. A method of decoding a string of serial binary code data to serial binary data, comprising the steps of:

   converting the serial string into j n-bit codewords;

   converting each n-bit codeword into a reassigned k-bit codeword representation, where k<n;

   collecting sets of j adjacent k-bit codeword representations;

   converting each reassigned codeword representation to an m-bit output corresponding to a then current set of j k-bit codeword representations; and

   converting successive m-bit outputs into the serial binary data.

9. The method of claim 8, wherein m is 2, n is 5, j is 4 and k is 3.

10. The method of claim 8 or 9, wherein during the second converting step, the n-bit codeword is converted sequentially into the reassigned k-bit codeword representation.

FIG. 1

FIG. 3

SERIAL DATA BITS IN 19

SERIAL TO 2 BIT PARALLEL CONVERSION 20

DATA BITS (2) $X_1, X_2$

PARALLEL OUT CLOCK $\emptyset/10$

SERIAL IN CLOCK $\emptyset/5$

ENCODER II

ROM LOOKUP TABLE (SEE TABLE 2) 21

CURRENT STATE (5) $S_1 \cdots S_5$

NEXT STATE (5) $S_1^* \cdots S_5^*$

5 BIT REGISTER 22

$\emptyset/10$

ENCODED BITS (5) $Y_1 \cdots Y_5$

5 BIT PARALLEL TO SERIAL CONVERTER 24

SERIAL CODE BIT OUT 23

PARALLEL IN CLOCK $\emptyset/10$

SERIAL OUT CLOCK $\emptyset/2$

FIG. 5

CLOCK

$Q_A$

$Q_B$

$Q_C$

*Fig-2*

DECODER 16

*Fig-4*